# DEMANDE DE BREVET EUROPEEN

(11) **EP 1 845 619 A1**
(43) Date de publication de la demande: **17.10.2007**
(21) Numéro de dépôt: 07105798.8
(22) Date de dépôt: 05.04.2007
(51) Int. Cl.: H03K 5/12, H03K 19/0185

(54) **Circuit tampon comprenant des moyens de contrôle de la pente du signal de sortie**

(30) Priorité: 13.04.2006 FR 0603308
(71) Demandeur: STMICROELECTRONICS SA, 92120 Montrouge (FR)
(72) Inventeur: Padilla, Thierry, 38400 Saint-Martin d'Hères (FR); Rien, Mikael, 38920 Crolles (FR)
(74) Mandataire: Bentz, Jean-Paul

(57) **Abrégé**

L'invention concerne un circuit tampon (BF) pour la transmission de signaux logiques (OUT+, OUT-), comprenant un premier buffer (40) pour fournir lesdits signaux logiques à destination d'un buffer de sortie (50) connecté en série avec le premier buffer pour délivrer lesdits signaux en sortie du circuit tampon, et des moyens de contrôle de la pente des signaux logiques délivrés en sortie permettant d'adapter la vitesse de transmission des signaux, ledit circuit tampon étant caractérisé en ce que ledit premier buffer et ledit buffer de sortie comprennent respectivement une porte logique réalisée en technologie CML, lesdits moyens de contrôle de la pente du signal de sortie comprenant un module de contrôle de pente (60), prévu pour appliquer un signal logique (SC) de programmation de la valeur d'une paire de résistances de sortie variables (36) de la porte CML constituant ledit premier buffer (40).

## Description

La présente invention concerne le transfert de données sur des liaisons séries à haut débit entre des modules électroniques émetteurs de données et des modules électroniques récepteurs de données. Elle concerne plus particulièrement un circuit tampon pour l'émission de signaux logiques, comprenant des moyens de contrôle de la pente du signal logique délivré en sortie.

Dans les circuits intégrés comprenant des moyens d'émission de données séries à haut débit, il est fréquent que les signaux logiques représentatifs des données à transmettre soient appliqués à des circuits tampons (« buffers ») assurant la mise en forme de ces signaux et l'adaptation d'impédance à l'entrée des circuits intégrés auxquels ils sont destinés.

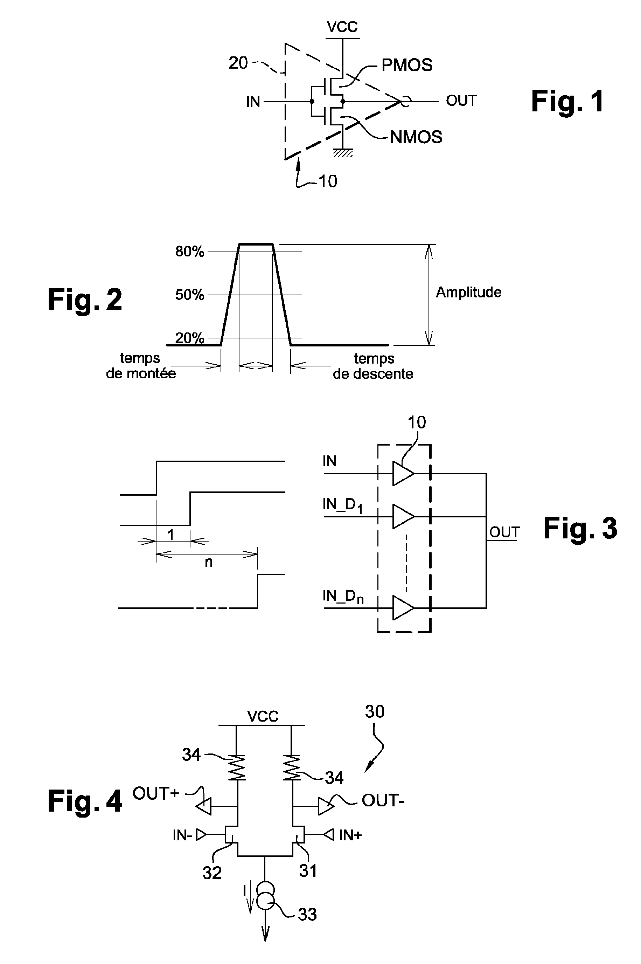

A titre d'exemple, la figure 1 représente un mode de réalisation classique d'un circuit tampon 10 au moyen d'une porte inverseuse 20. La porte inverseuse 20 comprend un transistor PMOS en série avec un transistor NMOS, la source du transistor PMOS étant polarisée par une tension d'alimentation Vcc et la source du transistor NMOS étant connectée à la masse. Le circuit tampon 10 reçoit en entrée un signal logique IN et délivre un signal de sortie OUT.

La structure du circuit tampon doit en fait être définie pour pouvoir tenir compte du standard de transfert de données auquel il va s'appliquer, notamment en ce qui concerne les spécifications temporelles des signaux transmis.

On suppose ici que le circuit tampon 10 est agencé dans un circuit intégré comprenant des moyens d'émission de données et conçu par exemple pour la transmission de données série à haut débit entre le processeur d'un ordinateur et un contrôleur de disque dur selon la norme de liaison série S-ATA (« Serial Advanced Technology Attachement »).

Ce standard présente à l'heure actuelle deux générations, respectivement S-ATA Gen1 et S-ATA Gen2, une troisième étant en cours de développement, définissant chacune des contraintes de spécification à prendre en compte pour le signal de sortie du circuit d'émission de données. Ces contraintes sont présentées dans le tableau ci-après.

| | | S-ATA Gen1 | S-ATA Gen2 |
|---|---|---|---|
| Temps de montée et de descente du signal de sortie du circuit d'émission (20%-80%) | min | 100ps | 67ps |
| | max | 273ps | 136ps |

Les contraintes de spécification pour la norme S-ATA Gen1 imposent donc d'avoir pour le signal de sortie délivré par le circuit tampon du circuit d'émission de données, un temps de montée et de descente du signal compris entre 100ps (picoseconde) et 273ps. La norme S-ATA Gen2 impose quant à lui d'avoir un temps de montée et de descente du signal de sortie compris entre 67ps et 136ps.

Ces temps sont typiquement mesurés entre les deux points correspondants respectivement à 20% et 80% de l'amplitude totale du signal de sortie. Pour fixer les idées, la figure 2 illustre ce qu'on entend par temps de montée, respectivement de descente, tels que spécifiés par la norme, sur un front montant, respectivement un front descendant, du signal de sortie représenté schématiquement.

En conséquence, la conception d'un circuit de transmission de données qui soit capable d'être compatible avec les deux générations du standard S-ATA implique, selon l'exemple ci-dessus, que les temps de montée et de sortie du signal de sortie délivré par le circuit tampon de sortie soient nécessairement compris dans la plage commune aux deux générations, soit entre 100ps et 136ps. Or, la plage temporelle commune aux deux générations de la norme est trop étroite pour qu'il soit possible de concevoir un circuit tampon assurant de tels temps de montée et de descente du signal de sortie compatibles aux deux générations de la norme, compte tenu des dispersions inhérentes au circuit.

Comme il ressort de la figure 2, les temps de montée et de descente du signal de sortie du circuit tampon sont fonction de la pente du signal. Plus la pente est forte, plus les temps de montée et descente sont rapides. A l'inverse, plus la pente est faible, plus les temps de montée et de descente sont lents. Partant de ces considérations, plutôt que de concevoir des circuits tampons de sortie dont l'architecture est spécifiquement conçue pour s'adapter aux contraintes temporelles d'une norme donnée au détriment de la compatibilité à d'autres normes, il a été envisagé des architectures laissant la possibilité de modifier la pente du signal de sortie pour être capable de répondre à différentes contraintes temporelles selon les normes.

Des solutions basées sur des portes en technologie CMOS telles qu'illustrées à la figure 1 ont été développées, offrant la possibilité de modifier la pente du signal de sortie. Leur principe de fonctionnement est illustré schématiquement à la figure 3 et consiste à introduire des retards dans la propagation du signal en amont du buffer. L'ajout de ces retards se fait de manière incrémentale, c'est-à-dire qu'on ajoute plus ou moins de retards élémentaires pour ralentir plus ou moins le signal en sortie du circuit tampon. Pour ce faire, une pluralité de buffers de sortie CMOS 10 est placée en parallèle et chacune des branches en parallèle reçoit sa propre commande, respectivement IN à IN_Dn, décalée dans le temps avec un certain retard, qui s'incrémente pour chaque branche (de 1 à n retards élémentaires). Ainsi, en ajoutant ou en retirant une branche aux autres pour la composition du signal de sortie résultant OUT pendant la phase de transition de ce signal, le temps de montée ou de descente du signal peut être modulé.

Cette solution n'est toutefois pas satisfaisante. Tout d'abord, le signal de sortie ainsi généré présente des discontinuités. Par ailleurs, l'architecture CMOS décrite ci-dessus présente des inconvénients en termes de bruit et d'intégrité des données. De plus, cette architecture de circuit tampon de sortie apporte peu de flexibilité et est limitée pour s'adapter à certains standards. En effet, une large plage de programmation de la pente du signal de sortie nécessiterait d'avoir un nombre de bits de programmation de plus en plus grand, ce qui serait contraignant d'une part, au niveau de la complexité du circuit et, d'autre part, au niveau de la taille occupée.

Un but de l'invention est donc de remédier à ces inconvénients en proposant une nouvelle architecture de circuit tampon de sortie, permettant la configuration de la pente du signal de sortie, pour s'adapter facilement à de nombreuses normes de transmission de données série haut débit, imposant des plages différentes de temps de montée et descente du signal de sortie.

Avec cet objectif en vue, l'invention a pour objet un Circuit tampon pour la transmission de signaux logiques, comprenant un premier buffer pour fournir lesdits signaux logiques à destination d'un buffer de sortie connecté en série avec le premier buffer pour délivrer lesdits signaux en sortie du circuit tampon, et des moyens de contrôle de la pente des signaux logiques délivrés en sortie permettant d'adapter la vitesse de transmission des signaux, ledit circuit tampon étant caractérisé en ce que ledit premier buffer et ledit buffer de sortie comprennent respectivement une porte logique réalisée en technologie CML, lesdits moyens de contrôle de la pente du signal de sortie comprenant un module de contrôle de pente, prévu pour appliquer un signal logique de programmation de la valeur d'une paire de résistances de sortie variables de la porte CML constituant ledit premier buffer.

Selon un mode de réalisation, la porte CML constituant le premier buffer comprend une paire de transistors d'entrée dont les drains, reliés à un potentiel d'alimentation haut par l'intermédiaire d'une résistance de sortie variable respective de la paire de résistances de sortie variables, fournissent les signaux logiques à destination du buffer de sortie, et une source de courant variable connectée entre la masse et les sources respectives de la paire de transistors d'entrée, ladite source de courant variable étant programmée par le signal de programmation délivré par le module de contrôle de pente.

Selon un mode de réalisation, la porte CML constituant le buffer de sortie comprend une paire de transistors d'entrée pilotés par les signaux logiques fournis en sortie du premier buffer, dont les drains sont reliés à un potentiel d'alimentation haut par l'intermédiaire de deux résistances de sortie respectives, et une source de courant connectée entre la masse et les sources respectives de la paire de transistors d'entrée, la pente des signaux logiques délivrés en sortie du buffer étant régie par la vitesse de la charge et de la décharge de la capacité grille-source des transistors d'entrée de la porte CML constituant le buffer de sortie.

Avantageusement, la valeur programmable, par l'intermédiaire du signal logique de programmation, de la paire de résistances de sortie variables de la porte CML constituant le premier buffer, permet de définir la vitesse de la charge et de la décharge de la capacité grille-source des transistors d'entrée de la porte CML constituant le buffer de sortie.

De préférence, chaque résistance variable de la paire de résistances de sortie variables de la porte CML constituant le premier buffer comprend une pluralité de résistances connectées en parallèle et des moyens, commandés par le signal de programmation, pour ajouter ou retirer des résistances parmi ladite pluralité de résistances en parallèle, de sorte à programmer une valeur globale de la résistance variable.

Avantageusement, la valeur globale initiale programmée pour la paire de résistances de sortie variables de la porte CML constituant le premier buffer est la valeur correspondant à l'ensemble de la pluralité de résistances prises en parallèle, permettant de programmer la pente la plus forte pour les signaux de sortie.

De préférence, la source de courant variable de la porte CML constituant le premier buffer comprend une pluralité de sources de courant connectées en parallèle et des moyens, commandés par le signal de programmation, pour ajouter ou retirer des sources de courant parmi ladite pluralité de sources de courant en parallèle, de sorte à programmer une valeur globale de la source de courant variable.

Avantageusement, la valeur de la source de courant variable est programmée de façon que le produit de la valeur de la résistance de sortie variable de la porte CML constituant le premier buffer par la valeur de la source de courant variable de la porte CML constituant le premier buffer reste constant quelle que soit la programmation de la valeur de la résistance de sortie variable.

Dans un exemple d'application, le circuit tampon selon l'invention est adapté à la transmission de données série à haut débit pour les différentes générations de la norme S-ATA.

L'invention concerne encore un circuit intégré comprenant un circuit tampon tel que précédemment décrit.

D'autres caractéristiques et avantages de la présente invention apparaîtront plus clairement à la lecture de la description suivante donnée à titre d'exemple illustratif et non limitatif et faite en référence aux figures annexées dans lesquelles :
- la figure 1, précédemment décrite, représente un circuit tampon classique,
- la figure 2, précédemment décrite, illustre les contraintes à prendre en compte pour le signal de sortie du circuit tampon, qui sont liées aux spécifications temporelles imposées par la norme,
- la figure 3 illustre une architecture connue de circuit tampon en technologie CMOS, permettant un contrôle de la pente du signal de sortie,
- la figure 4 illustre la structure d'une porte CML sur laquelle est basée l'architecture d'un circuit tampon selon l'invention,
- la figure 5 illustre l'architecture fonctionnelle d'un circuit tampon selon l'invention permettant d'assurer le contrôle de la pente du signal de sortie du circuit,
- la figure 6 illustre le principe de fonctionnement du contrôle de la pente du signal de sortie du circuit tampon selon la présente invention,
- la figure 7 illustre la structure logique du buffer d'entrée décrit à la figure 5, permettant d'assurer le contrôle de pente selon l'invention au niveau du signal de sortie.

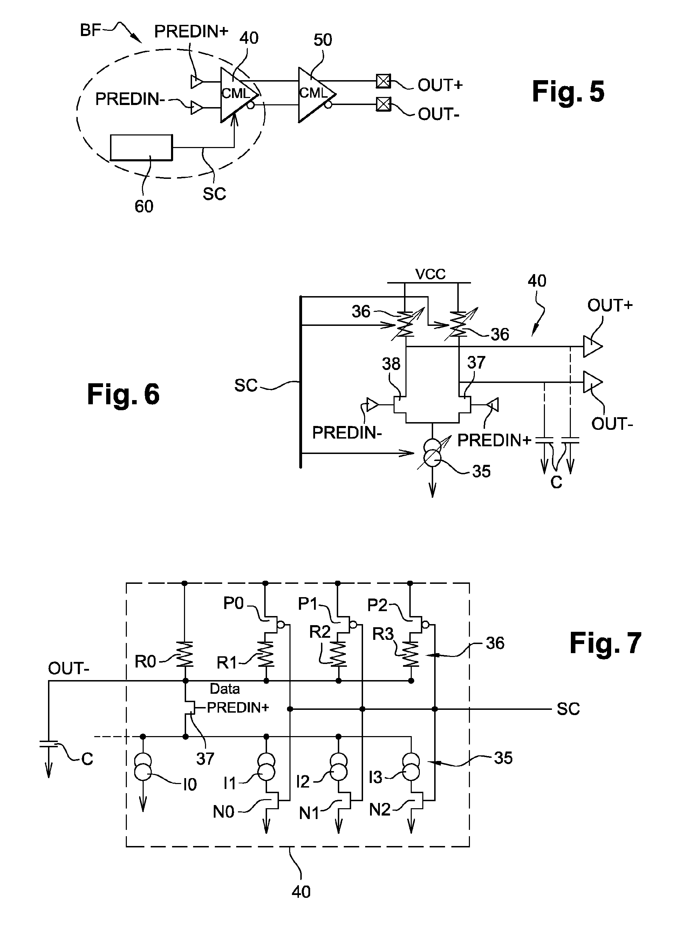

L'architecture du circuit tampon selon l'invention est basée sur l'utilisation de portes CML (« Current Mode Logic »), dont la structure est représentée à la figure 4.

Une porte CML 30 comprend une paire différentielle de transistors d'entrée 31, 32 de type nMOS, dont les drains sont reliés à un potentiel d'alimentation haut Vcc par l'intermédiaire de deux résistances de sortie respectives 34 de valeur R. La porte CML comprend également une source de courant 33 délivrant un courant I et connectée entre la masse et les sources respectives de la paire différentielle de transistors 31, 32.

Des signaux d'entrée différentiels IN+ et IN- sont appliqués respectivement au niveau des grilles des transistors 31, 32 de la paire de transistors d'entrée de la porte CML. Les sortie OUT- et OUT+ de la porte CML sont prélevées au niveau des drains respectifs des transistors 31 et 31 et délivrent des signaux en opposition de phase.

Ainsi, la source de courant 33 de la porte CML est prévue pour s'appliquer aux deux interrupteurs formés par la paire de transistors 31, 32 commandés en opposition de phase, qui permettent de venir charger la résistance de sortie 34 à tour de rôle. Soit l'interrupteur est ouvert (signal d'entrée à l'état bas appliqué sur la grille du transistor) et on a alors le signal Vcc sur la sortie correspondante, soit l'interrupteur est fermé (signal d'entrée à l'état haut appliqué sur la grille du transistor) et on a alors le signal Vcc-RI sur la sortie correspondante. La variation d'amplitude de la tension entre les deux niveaux atteint est donc égale à RI.

La figure 5 illustre l'architecture fonctionnelle d'un circuit tampon BF selon l'invention. Le circuit tampon BF comprend deux portes logiques CML en série, 40 et 50, formant respectivement l'étage d'entrée et l'étage de sortie. Chaque porte logique 40 et 50 est du type de celle décrite en référence à la figure 4. Le circuit tampon BF reçoit les signaux PREDIN+ et PREDIN- appliqués en entrée de la porte 40, et délivre en sortie les signaux OUT+ et OUT- fournis par la porte 50.

La porte CML 50, dont la structure est strictement identique à celle décrite à la figure 4, a donc un rôle de buffer de sortie, prévu pour transmettre les signaux finaux à destination de la charge extérieure du circuit. La porte 40, constitue quant à elle un premier buffer, dont le rôle est de préparer les signaux de sortie à transmettre pour soulager le buffer de sortie.

La caractéristique des signaux de sortie du circuit tampon BF est que leur pente peut être contrôlée. Pour ce faire, le circuit tampon BF comprend un module de contrôle de pente 60, prévu pour appliquer un signal logique SC de programmation au premier buffer 40. Ainsi, le contrôle de la pente du signal de sortie du circuit tampon s'effectue uniquement au niveau du premier buffer 40, comme il sera décrit plus précisément ci-après en référence à la figure 6.

La structure du premier buffer 40 est donc basée sur celle d'une porte CML telle que décrite à la figure 4, mais diffère néanmoins en ce qu'elle présente une source de courant 35 variable et une paire de résistances de sortie 36 variables, dont les valeurs respectives Ivar et Rvar sont définies en fonction du signal de programmation SC fourni par le module 60 de contrôle de pente. Les signaux d'entrée PREDIN+ et PREDIN- sont appliqués respectivement au niveau des grilles des transistors 37 et 38 de la paire de transistors d'entrée de la porte CML formant interrupteurs.

Le buffer de sortie 50 représente alors en sortie du premier buffer 40 une charge constante pouvant être symbolisée sur chaque ligne de sortie OUT+ et OUT- par deux capacités C, représentant chacune la capacité grille-source des transistors d'entrée 31, 32 de la porte CML du buffer de sortie. Ainsi, dans une phase intermédiaire où les signaux de sortie OUT+ et OUT- de la porte 40 sont entre les deux niveaux haut et bas, respectivement Vcc et Vcc-Rvar.Ivar, définissant l'excursion de tension de sortie de la porte, les signaux OUT+ et OUT- vont charger ou décharger les capacités C.

Sur chaque ligne de sortie du buffer 40, la pente du signal entre les deux niveaux haut et bas, définissant le temps de montée et de descente du signal de sortie, est donc régie par la rapidité de la charge et de la décharge de la capacité C, caractérisée par la constante de temps Rvar.C. Comme le buffer de sortie représente pour le premier buffer une charge constante, la modification de la valeur Rvar de la résistance de sortie 36 de la porte CML constituant le premier buffer 40 va permettre de modifier cette constante de temps et donc, d'augmenter ou de ralentir la vitesse de la charge de la capacité C, contrôlant ainsi la pente du signal de sortie.

Ce mécanisme est régi par le signal SC de programmation, qui permet de programmer la valeur de la paire de résistances de sortie variables 36 de la porte CML constituant le premier buffer 40, pour obtenir la pente désirée pour les signaux de sortie du buffer 40. Le signal SC permet également de programmer la valeur de la source de courant variable 35 du premier buffer 40. L'objectif est ici de pouvoir conserver l'excursion de tension constante en sortie du premier buffer 40, quelle que soit la programmation de la valeur de la résistance de sortie variable. En effet, comme déjà vu, cette excursion de tension est égale à la valeur du courant délivré par la source de courant multipliée par la valeur de la résistance de sortie de la porte CML. Ainsi, une modification de la valeur de la résistance aux fins du contrôle de pente du signal de sortie doit nécessairement être compensée par une adaptation en conséquence de la valeur du courant fourni par la source de courant, pour conserver cette excursion de tension constante.

Les signaux de sortie du premier buffer 40 vont alors être transférés au niveau de la sortie du buffer de sortie 50 du circuit tampon BF, avec les mêmes caractéristiques temporelles concernant leurs temps de montée et de descente que celles qui auront été définies par le mécanisme de contrôle agissant comme décrit plus haut sur le premier buffer 40. Les signaux de sortie délivrés par le premier buffer 40 vont plus précisément permettre de piloter les interrupteurs formés par la paire de transistors d'entrée 31, 32 de la porte CML constituant le buffer de sortie 50.

Les caractéristiques de temps de montée et de descente des signaux de sortie du buffer de sortie 50 vont donc être dictées par celles du premier étage constitué par le buffer 40, dont les caractéristiques temporelles intrinsèques sont dominantes. En effet, le temps de charge/décharge intrinsèque à l'étage de sortie 50 est très inférieur à celui du premier buffer 40.

La figure 7 illustre maintenant plus en détail un exemple de réalisation de la structure logique du premier buffer 40, permettant d'assurer le fonctionnement du mécanisme de contrôle de pente tel qu'il vient d'être décrit en référence à la figure 6. La figure 7 illustre en fait la moitié seulement de la structure du premier buffer 40. C'est-à-dire qu'une seule phase, par exemple OUT-, du signal de sortie est représentée.

On retrouve donc pour la phase décrite, la source de courant variable 35 de la porte CML, commune aux deux phases, prévue pour s'appliquer à l'interrupteur 37, permettant de venir charger une résistance de la paire de résistances de sortie variables 36 selon le signal PREDIN+ appliqué.

La structure est complètement symétrique pour l'autre phase du signal de sortie non représentée OUT+.

Selon l'exemple, la résistance de sortie variable 36 représentée est constituée par quatre branches en parallèle comprenant chacune respectivement une résistance R0 à R3. Des moyens sont prévus pour augmenter ou diminuer le nombre de branches placées en parallèle de sorte à moduler la valeur de la résistance variable 36. Plus précisément, les branches R1 à R3 comprennent chacune un transistor interrupteur de type P, respectivement P0 à P2, commandés par le signal logique SC. Ainsi, suivant la valeur du signal SC, on commande l'état fermé ou ouvert des interrupteurs P0 à P2, permettant en conséquence d'ajouter ou retirer la branche résistive correspondante et donc de moduler la valeur de la résistance variable globale 36.

Selon l'exemple de la figure 7, huit valeurs différentes de résistance de sortie 36 du buffer 40 et donc huit valeurs différentes de temps de montée et de descente du signal de sortie, pourraient être programmées en fonction des besoins d'adaptation à différentes normes de transmission.

Dans le même temps, il y a un contrôle de la valeur fournie par la source de courant variable 35, de sorte à conserver une excursion de tension de sortie constante selon la valeur de la résistance variable 36 programmée.

Pour ce faire, la source de courant variable comprend quatre branches en parallèle, comprenant chacune respectivement une source de courant Io à 13. Chaque branche I1 à 13 comprend en outre un transistor interrupteur de type N, respectivement N0 à N2, commandé par le signal logique SC, permettant d'ajouter ou retirer la branche de source de courant correspondante pour ainsi augmenter ou diminuer en conséquence la valeur globale du courant fourni par la source de courant variable 35.

Les transistors interrupteurs N0 à N2 sont plus précisément commandés par le signal logique SC de façon complémentaire par rapport aux transistors P0 à P2. Ainsi, lorsqu'un signal de commande à l'état bas, respectivement haut, est appliqué sur la grille du transistor P0, un signal de commande complémentaire à l'état haut, respectivement bas, est appliqué simultanément sur la grille du transistor interrupteur N0. Il en va de même pour les autres couples de transistors interrupteurs P1/N1 et P2/N2. Grâce à cette commande complémentaire des transistors interrupteurs de la résistance variable et de la source de courant variable, lorsqu'une branche est ajoutée, respectivement retirée, au niveau de la résistance variable 36, une branche correspondante est également ajoutée, respectivement retirée, au niveau de la source de courant variable.

En effet, lorsqu'on ajoute une branche résistive en parallèle au niveau de la résistance variable 36, la valeur globale de la résistance est diminuée, ce qui est compensé par le fait d'ajouter simultanément une branche de source de courant en parallèle, permettant d'augmenter en conséquence la valeur globale du courant fourni par la source variable. Egalement, lorsqu'on retire une branche résistive en parallèle au niveau de la résistance variable 36, la valeur globale de la résistance s'en trouve augmentée, ce qui est compensé par le fait de retirer simultanément une branche de source de courant en parallèle, permettant d'augmenter en conséquence la valeur globale du courant fourni par la source variable.

De cette manière, le produit de la valeur globale Rvar de la résistance variable 36 par la valeur globale Ivar de la source de courant variable 35 reste constant, cependant que la constante de temps Rvar.C définissant les caractéristiques de temps de montée et de descente du signal de sortie du buffer 40 peut être programmée par modulation de la valeur de la résistance Rvar, permettant ainsi d'adapter le circuit tampon à différentes normes de transmission définissant différentes spécifications temporelles pour les signaux de sortie.

Le nombre de branches en parallèle au niveau de la résistance variable et de la source de courant variable et donc le nombre de bits de programmation de la pente du signal de sortie composant le signal SC, permettant de commander l'ajout et le retrait simultanés de ces branches est ici donné à simple titre d'exemple.

La commande SC du contrôle de pente est effectuée de manière statique et définie avant le début de la transmission du signal. Autrement dit, il n'y pas de modification des bits de programmation composant la commande SC pendant les transitions du signal. De cette manière, on obtient un signal de sortie sans discontinuités.

La norme de transmission de données la plus rapide dicte les contraintes de conception du circuit tampon, c'est-à-dire que c'est elle qui impose les temps de montée et de descente les plus courts. Pour ce faire, le signal SC est programmé pour que l'ensemble des résistances R0 à R3 selon l'exemple soient placées en parallèle, pour fournir une valeur initiale globale Rvar de la résistance variable 36 la plus faible et donc la constante de temps Rvar.C la plus faible, correspondant à la pente la plus forte permise par l'architecture de circuit tampon. L'architecture proposée fournit alors la possibilité de s'adapter par la suite facilement à des normes imposant des spécifications temporelles plus lentes, en programmant le retrait d'une ou plusieurs résistances en parallèle, pour augmenter ainsi la valeur globale de la résistance variable, ce qui permet d'obtenir une valeur de constante de temps Rvar.C plus élevée et donc de ralentir le signal pour s'adapter à des normes plus lentes.

L'architecture de circuit tampon selon la présente invention est donc particulièrement avantageuse en ce qu'elle permet de prévoir un circuit tampon dont les moyens de contrôle de pente du signal de sortie sont facilement configurables, de manière à rendre le circuit compatible avec plusieurs générations de normes de transmission de données, en particulier pour la transmission de données série à haut débit.

L'utilité du contrôle de pente sur les signaux de sortie a ainsi été illustrée plus haut en référence à la norme S-ATA, mais l'invention ne se limite pas à cette norme et s'étend de manière générale à toute application de transmission de données différentielles en lien série.

## Revendications

1. Circuit tampon (BF) pour la transmission de signaux logiques (OUT+, OUT-), comprenant un premier buffer (40) pour fournir lesdits signaux logiques à destination d'un buffer de sortie (50) connecté en série avec le premier buffer pour délivrer lesdits signaux en sortie du circuit tampon, et des moyens de contrôle de la pente des signaux logiques délivrés en sortie permettant d'adapter la vitesse de transmission des signaux, ledit circuit tampon étant **caractérisé en ce que** ledit premier buffer et ledit buffer de sortie comprennent respectivement une porte logique réalisée en technologie CML, lesdits moyens de contrôle de la pente du signal de sortie comprenant un module de contrôle de pente (60), prévu pour appliquer un signal logique (SC) de programmation de la valeur d'une paire de résistances de sortie variables (36) de la porte CML constituant ledit premier buffer (40).

2. Circuit tampon selon la revendication 1, **caractérisé en ce que** la porte CML constituant le premier buffer (40) comprend une paire de transistors d'entrée (37, 38) dont les drains, reliés à un potentiel d'alimentation haut (Vcc) par l'intermédiaire d'une résistance de sortie variable respective de la paire de résistances de sortie variables (36), fournissent les signaux logiques (OUT+, OUT-) à destination du buffer de sortie (50), et une source de courant variable (35) connectée entre la masse et les sources respectives de la paire de transistors d'entrée, ladite source de courant variable étant programmée par le signal de programmation (SC) délivré par le module de contrôle de pente (60).

3. Circuit tampon selon la revendication 1 ou 2, **caractérisé en ce que** la porte CML constituant le buffer de sortie (50) comprend une paire de transistors d'entrée (31, 32) pilotés par les signaux logiques fournis en sortie du premier buffer (40), dont les drains sont reliés à un potentiel d'alimentation haut (Vcc) par l'intermédiaire de deux résistances de sortie respectives (34), et une source de courant (33) connectée entre la masse et les sources respectives de la paire de transistors d'entrée (31, 32), la pente des signaux logiques délivrés en sortie du buffer (50) étant régie par la vitesse de la charge et de la décharge de la capacité grille-source des transistors d'entrée de la porte CML constituant le buffer de sortie (50).

4. Circuit tampon selon la revendication 3,
**caractérisé en ce que** la valeur programmable, par l'intermédiaire du signal logique de programmation (SC), de la paire de résistances de sortie variables (36) de la porte CML constituant le premier buffer (40), permet de définir la vitesse de la charge et de la décharge de la capacité grille-source des transistors d'entrée de la porte CML constituant le buffer de sortie (50).

5. Circuit tampon selon l'une quelconque des revendications précédentes, **caractérisé en ce que** chaque résistance variable de la paire de résistances de sortie variables (36) de la porte CML constituant le premier buffer (40) comprend une pluralité de résistances (R0, R1, R2, R3) connectées en parallèle et des moyens (P0, P1, P2), commandés par le signal de programmation (SC), pour ajouter ou retirer des résistances parmi ladite pluralité de résistances en parallèle, de sorte à programmer une valeur globale de la résistance variable (36).

6. Circuit tampon selon la revendication 5,
**caractérisé en ce que** la valeur globale initiale programmée pour la paire de résistances de sortie variables (36) de la porte CML constituant le premier buffer (40) est la valeur correspondant à l'ensemble de la pluralité de résistances prises en parallèle, permettant de programmer la pente la plus forte pour les signaux de sortie.

7. Circuit tampon selon l'une quelconque des revendications précédentes en combinaison avec la revendication 2, **caractérisé en ce que** la source de courant variable (35) de la porte CML constituant le premier buffer (40) comprend une pluralité de sources de courant (10, I1, 12, 13) connectées en parallèle et des moyens (N0, N1, N2), commandés par le signal de programmation (SC), pour ajouter ou retirer des sources de courant parmi ladite pluralité de sources de courant en parallèle, de sorte à programmer une valeur globale de la source de courant variable (36).

8. Circuit tampon selon la revendication 7,
**caractérisé en ce que** la valeur de la source de courant variable est programmée de façon que le produit de la valeur de la résistance de sortie variable (36) de la porte CML constituant le premier buffer (40) par la valeur de la source de courant variable (35) de la porte CML constituant le premier buffer (40) reste constant quelle que soit la programmation de la résistance de sortie variable (36).

9. Circuit tampon selon l'une quelconque des revendications précédentes, **caractérisé en ce qu'**il est adapté à la transmission de données série à haut débit pour les différentes générations de la norme S-ATA.

10. Circuit intégré **caractérisé en ce qu'**il comprend un circuit tampon (BF) selon l'une quelconque des revendications précédentes.
